# EUROPEAN PATENT SPECIFICATION

(11) **EP 2 261 387 B1**
(45) Date of publication and mention of the grant of the patent: **29.10.2014**
(21) Application number: 10250652.4
(22) Date of filing: 30.03.2010
(51) Int. Cl.: C23C 14/30, H01J 37/16, H01J 37/305, H01J 37/317, C23C 14/56

(54) **Electron beam vapor deposition apparatus for depositing multi-layer coating**
Elektronenstrahl-Dampfabscheidungsvorrichtung zur Abscheidung einer Mehrlagenbeschichtung
Appareil de dépôt en phase vapeur par faisceau d'électrons pour le dépôt d'un revêtement multicouche

(30) Priority: 31.03.2009 US 414895
(43) Date of publication of application: 15.12.2010
(73) Proprietor: United Technologies Corporation, Hartford, CT 06101 (US)
(72) Inventor: Neal, James W., Ellington, Connecticut 06029 (US)
(74) Representative: Leckey, David Herbert

(56) References cited:
- EP-A1- 2 166 127
- WO-A2-2007/005832
- YU Z ET AL: "Vapor deposition of platinum alloyed nickel aluminide coatings" SURFACE AND COATINGS TECHNOLOGY, vol. 201, no. 6, 19 June 2006 (2006-06-19) , pages 2326-2334, XP024996233 ELSEVIER, AMSTERDAM [NL] ISSN: 0257-8972 DOI: 10.1016/J.SURFCOAT.2006.04.020 [retrieved on 2006-12-04]

## Description

### BACKGROUND OF THE INVENTION

This disclosure relates to coating equipment and, more particularly, to a coating apparatus and method that facilitate depositing a multi-layer coating on a substrate.

EP 2166127 A1, which was published after the priority date of the present application, discloses an electron beam vapor deposition apparatus and method. WO 2007/005832 discloses a thermal barrier coating system and related methods and apparatus for depositing such a coating system.

Physical vapor deposition ("PVD") is one common method for depositing a coating, such as a metallic coating or a ceramic coating, on a substrate. For instance, the coating may be a protective coating or a coating for promoting adhesion. One type of PVD process utilizes an electron beam gun to melt and vaporize a source material contained within a crucible. The vaporized source material condenses and deposits onto the substrate. Although generally effective, angled surfaces and non-line-of-sight surfaces relative to the source material in the crucible may not be uniformly coated or otherwise sufficiently coated. Moreover, the equipment used to deposit the coating may be designed or operated to deposit a single type of coating material, and using multiple types of coating materials for a multi-layer coating may cause cross-contamination and require a user to reconfigure the equipment for different types of coating material.

### SUMMARY OF THE INVENTION

The present invention provides a vapor deposition apparatus as set forth in claim 1.

The electron beam vapor deposition apparatus may also include first and second electron beam sources arranged to emit electron beams within, respectively, the first chamber and the second chamber. At least one gas source may be connected with the first DVD crucible and the second DVD crucible. A transport may move the work piece between the first and second chambers, and a controller may be configured with first control parameters that control deposition of first coating and second control parameters that control deposition of the second coating. At least one control parameter may be different between the first control parameters and the second control parameters.

The present invention also provides a method for use with a vapor deposition apparatus, as set forth in claim 10.

### BRIEF DESCRIPTION OF THE DRAWINGS

The various features and advantages of the disclosed examples will become apparent to those skilled in the art from the following detailed description. The drawings that accompany the detailed description can be briefly described as follows.
Figure 1 illustrates an example electron beam vapor deposition apparatus.
Figure 2 illustrates a cross-section of the directed vapor deposition apparatus of Figure 1.
Figure 3 illustrates an example of a directed vapor deposition crucible for use with the deposition apparatus.
Figure 4 illustrates an example of the operation of the directed vapor deposition crucible.
Figure 5 illustrates another example directed vapor deposition crucible for use with the deposition apparatus.

### DETAILED DESCRIPTION OF THE PREFERRED EMBODIMENT

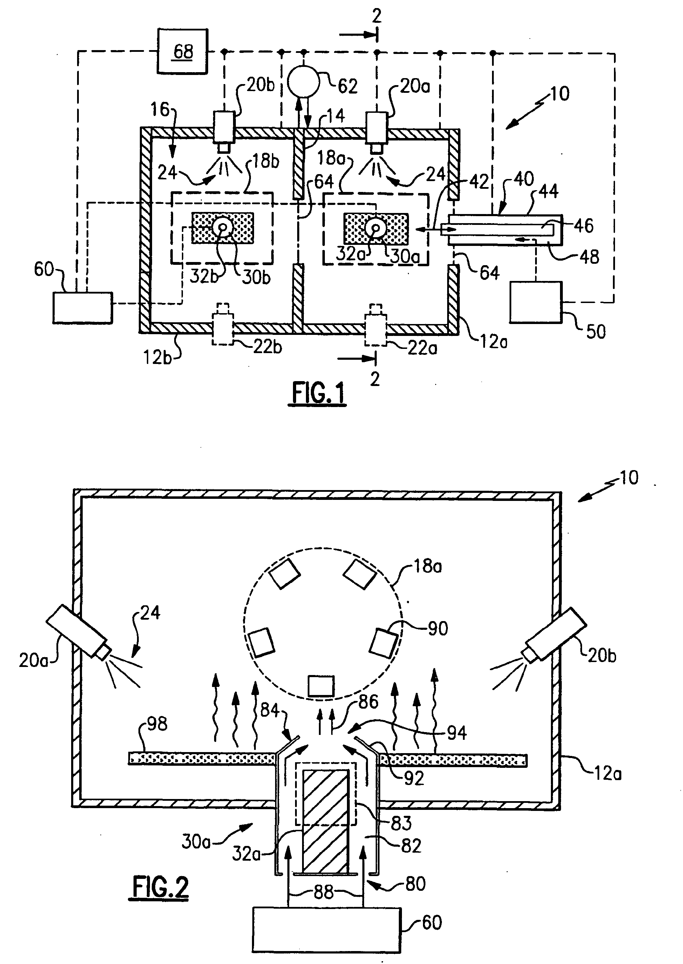

Figure 1 illustrates selected portions of an example vapor deposition, such as an electron beam physical vapor deposition ("EBPVD") apparatus 10 for depositing one or more materials, such as a multi-layer coating, on one or more work pieces. As an example, the work pieces may include turbine engine airfoils, such as gas turbine blades or vanes or other components. The coating layers may be a metallic, ceramic, or other type of coating material suited for vapor deposition. In one example, a first layer of the multi-layer coating may be yttria stabilized zirconia ("YSZ") and a second, top layer may be gadolinia stabilized zirconia ("GSZ"). In this regard, the work piece may include a metallic bond coat and thermally grown oxide to facilitate adhesion between the layers and a nickel-based alloy substrate.

As will be discussed, the EBPVD apparatus 10 facilitates depositing the multi-layer coating on one or more work pieces. For instance, the EBPVD apparatus 10 may facilitate depositing material on angled surfaces and non-line-of-sight surfaces of a work piece and facilitates depositing multiple layers of different compositions with reduced contamination.

The EBPVD apparatus 10 includes a first chamber or coating chamber 12a and a second chamber (or coating chamber) 12b located immediately adjacent to the first chamber 12a. The first chamber 12a and the second chamber 12b may share a common wall 14.

The first chamber 12a includes a first coating zone 18a and the second chamber 12b includes a second coating zone 18b. For instance, the first coating zone 18a and the second coating zone 18b include a spatial volume within the respective chamber 12a or 12b where one or more work pieces may be coated.

One or more devices known in the art are provided for evaporating materials to be deposited on a work piece. For example, a first electron beam source 20a and a second electron beam source 20b are arranged to emit electron beams within, respectively, the first chamber 12a and the second chamber 12b. For instance, the first electron beam source 20a and the second electron beam source 20b may be mounted using known techniques to the walls of the chambers 12a and 12b.

Optionally, the chambers 12a and 12b may include additional electron beam sources 22a and 22b. The first electron beam sources 20a and 20b and the additional electron beam sources 22a and 22b are operative to emit electron beams 24 in directions toward the respective first coating zone 18a and second coating zone 18b to coat the work piece(s).

A first directed vapor deposition (DVD) crucible 30a is adjacent to the first coating zone 18a for presenting a first source coating material 32a, and a second directed vapor deposition (DVD) crucible 30b is adjacent to the second coating zone 18b for presenting a second source coating material 32b. As an example, the first source coating material 32a and the second source coating material 32b may be ingots of metallic or ceramic material as described above that will later be melted and evaporated 24 to coat the work pieces.

A transport 40 is configured to move back and forth along direction 42 between the first chamber 12a and the second chamber 12b. The transport 40 serves to move the work piece(s) between the first coating zone 18a and the second coating zone 18b. For example, one or more work pieces may be mounted to the transport 40 and manually or automatically moved between the first chamber 12a and the second chamber 12b.

The transport 40 may be any type of mechanical device for moving one or more work pieces between the first chamber 12a and the second chamber 12b. In one example, the transport 40 includes a static outer shaft 44 and a movable drive shaft 46 arranged concentrically within the static outer shaft 44. The movable drive shaft 46 may be extended and retracted between the first chamber 12a and the second chamber 12b. The static outer shaft 44 may also be used to support other devices for facilitating the coating process, such as a thermal hood disclosed in copending and commonly owned application EP 2157204 A1, entitled DEPOSITION APPARATUS HAVING THERMAL HOOD.

Optionally, the static outer shaft 44 may be radially spaced apart from the moveable drive shaft 46 such that there is a gas flow passage 48 there between. The gas flow passage 48 opens to the interior of the first chamber 12a and may be fluidly connected with a gas source 50, such as an oxygen gas source. The gas from the gas source 50 may be used for a preheating cycle to oxidize the surfaces of the work piece(s) in preparation for the coating process.

A gas source 60 is fluidly connected with the first and second DVD crucibles 30a and 30b for providing a carrier gas, as will be described below. A single gas source 60 may be used to provide carrier gas for both the first and second DVD crucibles 30a and 30b. Alternatively, multiple gas sources 60 may be used such that each of the first and second DVD crucibles 30a and 30b has a dedicated source.

The EBPVD apparatus 10 may also include a cooling device 62 for circulating a coolant through the walls of the chambers 12a and 12b to maintain the chambers at a desired temperature. Additionally, a gate valve 64 may be provided between the first chamber 12a and the second chamber 12b for providing a gas tight seal and thermal partitioning. Another gate valve 64 may be provided near the transport 40, to permit movement of the transport 40 into and out from the first chamber 12a.

A controller 68 may be coupled to and control the EBPVD apparatus 10, such as the first and second DVD crucibles 30a and 30b, gas sources 50 and 60, the cooling device 62, the electron beam sources 20a, 20b, 22a, and 22b, gate valves 64, and transport 40 to control the deposition of the multi-layer coating. The controller 68 may include hardware (e.g., a microprocessor), software, or both.

Figure 2 illustrates a section according to Figure 1 through the first chamber 12a. It is to be understood that the second chamber 12b may be substantially similarly configured to the first chamber 12a. Each of the first and second DVD crucibles 30a and 30b include an inlet 80 fluidly coupled to the gas source 60. For instance, the inlet 80 may be a fitting or connector. The inlet 80 is fluidly connected with a gas flow passage 82 that is exposed to the source coating material 32a, which can be mounted in or moved into a heating zone 83. The gas flow passage 82 extends between the inlet 80 and a nozzle portion 84 that emits a coating stream 86 of vaporized source coating material 32a entrained in a carrier gas 88 provided by the gas source 60. That is, as the electron beams 24 irradiate the heating zone 83 to vaporize the source coating material 32a. The vaporized coating source material 32a becomes entrained in the carrier gas 88 flowing through the gas flow passage 82. The coating stream 86 flows from the nozzle portion 84 toward one or more work pieces 90 within the first coating zone 18b.

In the illustrated example, the nozzle portion 84 includes a funnel 92 having an outlet orifice 94 fluidly connected with the flow passage 82 for jetting the coating stream 86 from the first DVD crucible 30a to deposit the source coating material 32a on the work pieces 90. In this regard, the term directed vapor deposition may generally refer to using a jetted or accelerated gas stream to deposit a material, such as a coating.

The DVD crucibles 30a and 30b may be positioned an appropriate stand-off distance (e.g., horizontal and/or vertical distance) from the respective coating zones 18a and 18b to facilitate the directed vapor deposition. The stand-off distance is a function of the design of the crucibles 30a and 30b and the geometry of the work pieces being coated. For example, the stand-off distance may be less than a stand-off distance typically used for physical vapor deposition that does not use jetting. In one example, the stand-off distance may be about six to twelve inches (about 15.2 to 35.6 centimeters). A shorter stand-off distance provides the benefit of accurately aiming the coating stream 86.

The example EBPVD apparatus 10 may be used to deposit a multi-layer coating on all or selected surfaces of a work piece(s), including angled surfaces and non-line-of-sight surfaces such as between paired turbine vanes that may include only fractions of an inch between airfoils. For example, the transport 40 may move a work piece into the first coating zone 18a of the first chamber 12a. The first chamber 12a may be evacuated to a predetermined pressure and heated to a predetermined temperature before the coating process begins. The first electron beam source 20a may then be activated to melt and vaporize the first source coating material 32a. The first electron beam source 20a may also be used to heat the work pieces and/or a water-cooled tray 98 that contains pellets having an identical composition as the source coating material to radiantly heat the work pieces to the desired coating temperature (or a pre-heat temperature for providing a thermally grown oxide). The vaporized first coating source material 32a deposits onto the work piece as a first coating layer.

The transport 40 may then move the work pieces into the second coating zone 18b of the second chamber 12b. The second chamber 12b may be evacuated to a predetermined pressure and heated to a predetermined temperature before the coating process begins. The second electron beam source 20b is then activated to melt and vaporize the second source coating material 32b and deposit a second coating layer on the work piece(s). Thus, the EBPVD apparatus 10 provides the benefit of depositing a multi-layered coating on the work piece(s). Moreover, the coating layers may be of different compositions, depending on the compositions of the first source coating material 32a and the second source coating material 32b, with reduced risk of cross-contamination.

In that regard, the first chamber 12a may be configured to deposit a first coating on the work pieces 90 and the second chamber 12b may be configured to deposit a second, different coating on the work pieces 90. Therefore, a premise of the disclosed examples is that each of the first and second chambers 12a and 12b can be individually configured to deposit a different composition of coating material, and thereby avoid contamination and having to reconfigure a single coating chamber for different coating materials.

As an example, the coatings may be ceramic coatings such as YSZ and GSZ as described above. YSZ has a melting temperature around 2800°C and GSZ has a melting temperature of around 2300°C. The melting temperatures are generally proportional to the evaporation temperatures. Therefore, if source materials for YSZ and GSZ are included within a single chamber, the higher temperature used to first deposit the YSZ on a substrate or bond coat will melt and evaporate the GSZ in the chamber and may thereby contaminate the YSZ layer with GSZ. Even if the GSZ is not included within the chamber, amounts of GSZ may remain in the chamber from prior coating cycles and cause cross-contamination. Cross-contamination of the YSZ and GSZ may reduce the durability of the multi-layer coating. That is, the inventor has discovered that pure layers of YSZ and GSZ are desired to achieve a more durable multi-layer coating that is more resistant to spalling.

The controller 68 is configured with first control parameters that control deposition of the first material and second control parameters that control deposition of the second material. At least one control parameter is different between the first control parameters and the second control parameters such that the different material layers can be deposited. As an example, the deposition temperature, electron beam focus, filament current, scanning area, electron beam power density, stand-off distance, carrier gas flow, chamber pressure, or other parameters may have different values between the first and second control parameters to effect deposition of the different coating materials. For instance, the temperature needed to deposit YSZ is higher than the temperature needed to deposit GSZ. The first control parameters may therefore utilize a different beam focus, filament current, scanning area, and power density than is used for the second control parameters.

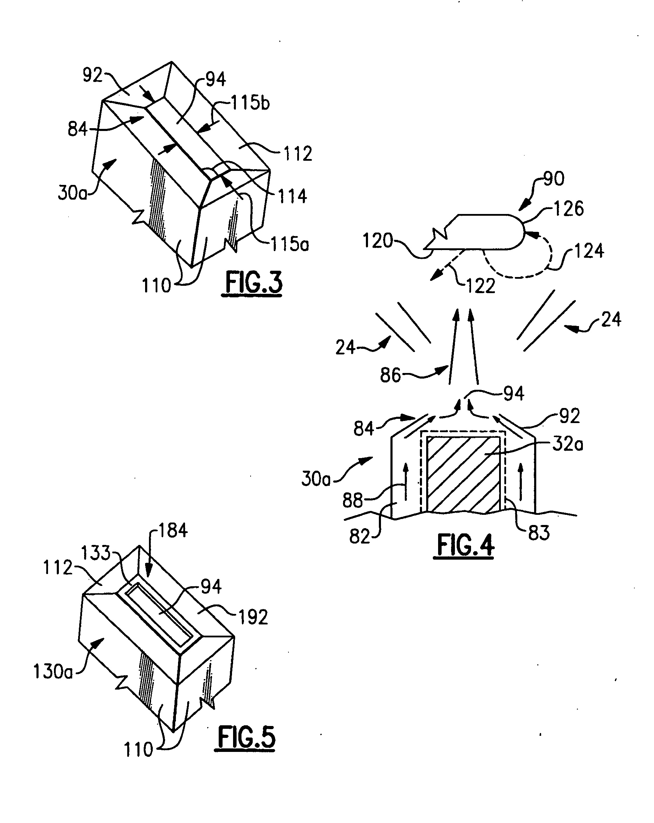

Figure 3 illustrates a portion of the first DVD crucible 30a but is also representative of the arrangement of the second DVD crucible 30b. In this example, the outlet orifice 94 has a rectilinear cross-section. That is, the outlet orifice 94 has a cross-sectional area formed with at least one straight line side but in this case has four straight line sides. In other examples, the cross-section of the outlet orifice 94 may be circular, oval, or another polygonal shape having any desired number of straight line sides. Given this description, one of ordinary skill in the art will be able to recognize cross-sectional shapes of the outlet orifice 94 to meet their particular needs.

The example first DVD crucible 30a includes four planar side walls 110 (two shown) arranged in a parallelogram. In other examples, the first DVD crucible 30a may include fewer or additional side walls that are geometrically or non-geometrically arranged, a curved side wall, or combinations thereof.

The funnel 92 of the nozzle portion 84 may include one or more sloped walls 112 that extend between the side walls 110 and the outlet orifice 94. For example, there may be one sloped wall 112 corresponding to each planar side wall 110, a sloped wall 112 with curved corners, or a combination thereof. In the example shown, each sloped wall 112 is connected on two opposed sides to two other respective sloped walls 112, and spans between the planar side wall 110 and the outlet orifice 94. The sloped walls 112 may be planar such that the planes are angled with respect to the planar side walls 110 to form the funnel 92.

The funnel 92 is fluidly connected with the flow passage 82. The reduction in cross-sectional area increases flow rate and thereby "jets" the coating stream 86 from the outlet orifice 94. The jetted coating stream 86 may be aimed at a particular portion or portions of one or more of the work pieces 90 that are to be coated.

The first DVD crucible 30a may be formed from any suitable type of material. In one example, the material is a refractory material, such as a ceramic, or an alloy material that resists the temperatures generated during the coating prowess, In some examples, the first DVD crucible 30a may be a cooled structure to facilitate temperature resistance.

Figure 4 illustrates an example of using the first DVD crucible 30a to facilitate coating the work piece 90. The rectilinear cross-section of the outlet orifice 94 facilitates coating transversely oriented surfaces (i.e., surfaces non-perpendicularly oriented to the flow direction of the coating stream 86) and non-line-of-sight surfaces of the work pieces 90. For instance, the straight line sides of the outlet orifice 94 meet at corners 114 (Figure 3). The corners 114 may contribute to random collisions among the particles in the coating stream 86 from the outlet orifice 94 such that the coating stream 86 generally moves toward the coating zone 18a. When the coating stream 86 impinges upon a line-of-sight surface 120 of the work piece 90, the carrier gas and any undeposited source coating material may deflect off of the line-of-sight surface 120. The random collisions among the particles in the coating stream 86 randomize the direction of deflection. For instance, a portion of the deflected material may deflect in direction 122 and another portion may deflect along direction 124. Thus, instead of always deflecting back toward the first DVD crucible 30a, the undeposited material deflects in random directions and may thereby deflect toward a transversely oriented surface or a non-line-of-sight surface, such as non-line-of-sight surface 126 of the work piece 90.

The first DVD crucible 30a thereby facilitates depositing the coating on transversely oriented surfaces and non-line-of-sight surfaces.

The rectilinear cross-section of the outlet orifice 94 also provides a favorable shape of the coating stream 86. For instance, the rectilinear cross-section creates a cone-shaped flow stream that facilitates accurately directed the coating stream 86 at the work pieces 90.

The line-of-sight surface 120 being coated may be near a corner or fillet radius, and the randomized deflection may also reduce interference with the incoming coating stream 86 to facilitate coating the line-of-sight surface 120.

The coating stream 86 may also directly impinge upon and coat transversely oriented surfaces and non-line-of-sight surfaces. For instance, vaporized source coating material flowing within the coating stream 86 may flow along a curved path around an edge of the work piece 90 to impinge upon and coat a transversely oriented surface or non-line-of-sight surface that is adjacent to the edge.

Additionally, the first DVD crucible 30a may be used to facilitate forming a desired orientation of the coating on the transversely oriented surfaces and non-line-of-sight surfaces. For instance, the coating generally forms in a columnar microstructure with a columnar axis approximately parallel to the flow direction of the coating stream 86. On a line-of sight surface, the microstructural columns would be approximately perpendicular to the line-of-sight surface. Without the random collisions among the particles in the coating stream 86, the microstructural columns formed on transversely oriented surfaces would not be perpendicular to the transversely oriented surfaces. With the random collisions in the coating stream 86 though, the deflected material impinges the transversely oriented surface at a steeper angle (e.g., approaching perpendicular) such that the columns would be approximately perpendicular to the surface. For example, perpendicular microstructural columns may be desirable on all surfaces for enhanced durability.

The flow of coating stream 86 may be designed to achieve a desired coating effect. For instance, the example outlet orifice 94 has an aspect ratio of length 115a (Figure 3) to width 115b that is greater than one. In some examples, the aspect ratio may be designed to provide a desired shape of the coating stream 86 to produce a desired coating effect or coating orientation. Likewise, the number of straight line sides of the outlet orifice 94 or the angles of the corners 114 between the sides may be designed to influence the coating stream. Additionally, the influence of the geometry of the outlet orifice 94 may be used in combination with controlling other parameters, such as the stand-off distance between the work pieces 90 and the first DVD crucible 30a, the steady state inputs of the EBPVD apparatus 10 (e.g., pressures, gas flows, etc.), and auxiliary jet flows to further direct the coating stream 86 or deflected undeposited material, for example.

Figure 5 illustrates another example first DVD crucible 130a that is similar to the first DVD crucible 30a of the previous example and may be used in the EBPVD apparatus 10. In this disclosure, like reference numerals designate like elements where appropriate. A nozzle portion 184 includes a funnel 192 having a top wall 133 that extends between the outlet orifice 94 and the sloped walls 112. For example, the top wall 113 is planar and is approximately perpendicularly oriented relative to the planar side walls 110.

As may be appreciated, the carrier gas and entrained coating material flowing through the flow passage 82 may impinge upon the top wall 113 before exiting through the outlet orifice 94 to produce random collisions among the particles within the coating stream 86.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments.

The preceding description is exemplary rather than limiting in nature. Variations and modifications to the disclosed examples may become apparent to those skilled in the art that do not necessarily depart from the essence of this disclosure. The scope of legal protection given to this disclosure can only be determined by studying the following claims.

## Claims

1. A vapor deposition apparatus comprising:
first and second chambers (12a,12b);
a first directed vapor deposition (DVD) crucible (30a) at least partially within the first chamber (12a) for presenting a first source material (32a) to be deposited on a work piece; and
a second directed vapor deposition (DVD) crucible (30b) at least partially within the second chamber (12b) for presenting a second, different source material (32b) to be deposited on the work piece;
**characterised in that** each of the first DVD crucible (30a) and the second DVD crucible (30b) includes a gas inlet port, a heating zone for presenting the corresponding first source material or second source material, a flow passage (82) exposed to the heating zone (83) and fluidly connected with the inlet port (80), and a nozzle portion (84) including an outlet orifice (94) fluidly connected with the flow passage (82) for jetting a gas stream, wherein the nozzle portion (84) includes a funnel (92) through which the output orifice (94) extends.

2. The apparatus as recited in claim 1, further comprising a controller (68) configured with first control parameters that control deposition of the first source material (32a) and second control parameters that control deposition of the second source material (32b), and at least one control parameter is different between the first control parameters and the second control parameters.

3. The apparatus as recited in any preceding claim, wherein each of the first and second chambers (12a,12b) includes a zone for depositing the respective first material (32a) and the second material (32b).

4. The apparatus as recited in any preceding claim, further comprising first and second electron beam sources (20a,20b,22a,22b) arranged to emit electron beams within, respectively, the first and second chambers (12a,12b).

5. The apparatus as recited in any preceding claim, further comprising at least one gas source (60) connected, optionally directly connected, with the first DVD crucible (30a) and the second DVD crucible (30b).

6. The apparatus as recited in any preceding claim, further comprising a transport (40) for moving the work piece between the first and second chambers (12a,12b).

7. The apparatus as recited in any preceding claim, further comprising a gate valve (64) between the first and second chambers (12a,12b), optionally to isolate the chambers from each other.

8. The apparatus as recited in claim 1, wherein the outlet orifice (94) has a cross-section having four straight line sides.

9. The apparatus as recited in claim 1, wherein the outlet orifice (94) has a rectilinear cross-section.

10. A method for use with a physical vapor deposition apparatus, the method comprising:
depositing a first material (32a) on a work piece using a first directed vapor deposition (DVD) crucible (30a) that is at least partially within a first chamber (12a); and
depositing a second, different material (32b) on the work piece using a second directed vapor deposition (DVD) crucible (30b) that is at least partially within a second chamber (12b) that is adjacent to the first chamber (12a);
**characterised in that** each of the first DVD crucible (30a) and the second DVD crucible (30b) includes a gas inlet port, a heating zone for presenting the corresponding first source material or second source material, a flow passage (82) exposed to the heating zone (83) and fluidly connected with the inlet port (80), and a nozzle portion (84) including an outlet orifice (94) fluidly connected with the flow passage (82) for jetting a gas stream, wherein the nozzle portion (84) includes a funnel (92) through which the outlet orifice (94) extends, wherein depositing the first coating and depositing the second coating each includes jetting evaporated source coating material in a carrier gas toward the work piece, the method further comprising:
jetting the evaporated source coating material in the carrier gas from the outlet orifice (94) of the funnel (92).

11. The method as recited in claim 10, wherein the depositing of the first material (32a) and the second material (32b) includes depositing by electron beam physical vapor deposition.

12. The method as recited in claim 10 or 11, further comprising controlling deposition of the first material (32a) with first control parameters and controlling deposition of the second material (32b) with second control parameters, wherein at least one control parameter is different between the first control parameters and the second control parameters.

13. The method as recited in claim 10, wherein the outlet orifice (94) has a cross-section having four straight line sides.

14. The method as recited in claim 10, wherein the outlet orifice (94) has a rectilinear cross-section.

## Patentansprüche

1. Dampfphasen-Abscheidungsvorrichtung, aufweisend:
eine erste und eine zweite Kammer (12a, 12b);
einen ersten Tiegel für gerichtete Dampfphasenabscheidung (DVD-Tiegel) (30a), der zumindest teilweise innerhalb der ersten Kammer (12a) angeordnet ist, um ein erstes Ausgangsmaterial (32a) darzubieten, das auf einem Werkstück abgeschieden werden soll; und
einen zweiten Tiegel für gerichtete Dampfphasenabscheidung (DVD-Tiegel) (30b), der zumindest teilweise innerhalb der zweiten Kammer (12b) angeordnet ist, um ein zweites, anderes Ausgangsmaterial (32b) darzubieten, das auf dem Werkstück abgeschieden werden soll;
**dadurch gekennzeichnet, dass** der erste DVD-Tiegel (30a) und der zweite DVD-Tiegel (30b) jeweils eine Gaseinlassöffnung, eine Heizzone zum Darbieten des entsprechenden ersten Ausgangsmaterials oder zweiten Ausgangsmaterials, eine Strömungspassage (82), die der Heizzone (83) ausgesetzt ist und mit der Einlassöffnung (80) in Fluidverbindung steht, sowie einen Düsenbereich (84) aufweist, der eine mit der Strömungspassage (82) in Fluidverbindung stehende Auslassöffnung (94) zum Ausstoßen eines Gasstroms beinhaltet, wobei der Düsenbereich (84) einen Trichter (92) aufweist, durch den sich die Auslassöffnung (94) hindurch erstreckt.

2. Vorrichtung nach Anspruch 1,
weiterhin mit einer Steuerung (68), die mit ersten Steuerparametern, die das Abscheiden des ersten Ausgangsmaterials (32a) steuern, sowie mit zweiten Steuerparametern versehen ist, die das Abscheiden des zweiten Ausgangsmaterials (32b) steuern, wobei zwischen den ersten Steuerparametern und den zweiten Steuerparametern zumindest ein Steuerparameter anders ist.

3. Vorrichtung nach einem der vorhergehenden Ansprüche,
wobei die erste und die zweite Kammer (12a, 12b) jeweils eine Zone zum Abschieden des ersten Materials (32a) bzw. des zweiten Materials (32b) aufweisen.

4. Vorrichtung nach einem der vorhergehenden Ansprüche,
weiterhin mit ersten und zweiten Elektronenstrahlquellen (20a, 20b, 22a, 22b), die zum Emittieren von Elektronenstrahlen innerhalb der ersten bzw. der zweiten Kammer (12a, 12b) angeordnet sind.

5. Vorrichtung nach einem der vorhergehenden Ansprüche,
weiterhin mit mindestens einer Gasquelle (60), die mit dem ersten DVD-Tiegel (30a) und dem zweiten DVD-Tiegel (30b) verbunden ist, optional in gerichteter Weise mit diesen verbunden ist.

6. Vorrichtung nach einem der vorhergehenden Ansprüche,
weiterhin mit einer Transporteinrichtung (40) zum Bewegen des Werkstücks zwischen der ersten und der zweiten Kammer (12a, 12b).

7. Vorrichtung nach einem der vorhergehenden Ansprüche,
weiterhin mit einem Absperrschieber (64) zwischen der ersten und der zweiten Kammer (12a, 12b), optional zum Trennen der Kammern voneinander.

8. Vorrichtung nach Anspruch 1,
wobei die Auslassöffnung (94) einen Querschnitt mit vier geradlinigen Seiten aufweist.

9. Vorrichtung nach Anspruch 1,
wobei die Auslassöffnung (94) einen geradlinigen Querschnitt aufweist.

10. Verfahren zur Verwendung bei einer physikalischen Dampfphasen-Abscheidungsvorrichtung, wobei das Verfahren folgende Schritte aufweist:
Abscheiden eines ersten Materials (32a) auf einem Werkstück unter Verwendung eines ersten Tiegels für gerichtete Dampfphasenabscheidung (DVD-Tiegel) (30a), der zumindest teilweise innerhalb einer ersten Kammer (12a) angeordnet ist; und
Abscheiden eines zweiten, anderen Materials (32b) auf dem Werkstück unter Verwendung eines zweiten Tiegels für gerichtete Dampfphasenabscheidung (DVD-Tiegel) (30b), der zumindest teilweise innerhalb einer zweiten Kammer (12b) angeordnet ist, die der ersten Kammer (12a) benachbart ist;
**dadurch gekennzeichnet, dass** der erste DVD-Tiegel (30a) und der zweite DVD-Tiegel (30b) jeweils eine Gaseinlassöffnung, eine Heizzone zum Darbieten des entsprechenden ersten Ausgangsmaterials oder zweiten Ausgangsmaterials, eine Strömungspassage (82), die der Heizzone (83) ausgesetzt ist und mit der Einlassöffnung (80) in Fluidverbindung steht, sowie einen Düsenbereich (84) aufweist, der eine mit der Strömungspassage (82) in Fluidverbindung stehende Auslassöffnung (94) zum Ausstoßen eines Gasstroms beinhaltet, wobei der Düsenbereich (84) einen Trichter (92) aufweist, durch den sich die Auslassöffnung (94) hindurch erstreckt, wobei das Abscheiden der ersten Beschichtung und das Abscheiden der zweiten Beschichtung jeweils das Ausstoßen von verdampftem Beschichtungs-Ausgangsmaterial in einem Trägergas in Richtung auf das Werkstück beinhaltet, wobei das Verfahren ferner beinhaltet:
Ausstoßen des verdampften Beschichtungs-Ausgangsmaterials in dem Trägergas von der Auslassöffnung (94) des Trichters (92).

11. Verfahren nach Anspruch 10,
wobei das Abscheiden des ersten Materials (32a) und des zweiten Materials (32b) das Abscheiden durch physikalische Elektronenstrahl-Dampfphasenabscheidung beinhaltet.

12. Verfahren nach Anspruch 10 oder 11,
das ferner das Steuern des Abscheidens des ersten Materials (32a) mit ersten Steuerparametern und das Steuern des Abscheidens des zweiten Materials (32b) mit zweiten Steuerparametern beinhaltet, wobei zwischen den ersten Steuerparametern und den zweiten Steuerparametern mindestens ein Steuerparameter anders ist.

13. Verfahren nach Anspruch 10,
wobei die Auslassöffnung (94) einen Querschnitt mit vier geradlinigen Seiten aufweist.

14. Verfahren nach Anspruch 10,
wobei die Auslassöffnung (94) einen geradlinigen Querschnitt aufweist.

## Revendications

1. Un appareil de dépôt en phase vapeur comprenant :
des première et seconde chambres (12a, 12b) ;
un premier creuset (30a) de dépôt en phase vapeur dirigé (DVD) au moins partiellement à l'intérieur de la première chambre (12a) pour présenter un premier matériau source (32a) à déposer sur une pièce de travail ; et
un seconde creuset (30b) de dépôt en phase vapeur dirigé (DVD) au moins partiellement à l'intérieur de la seconde chambre (12b) pour présenter un second matériau source différent (32b) à déposer sur la pièce de travail ;
**caractérisé en ce que** chacun du premier creuset DVD (30a) et du second creuset DVD (30b) inclut un orifice d'entrée de gaz, une zone de chauffage pour présenter le premier matériau source ou le second matériau source correspondant, un passage de flux (82) exposé à la zone de chauffage (83) et connecté de manière fluidique avec l'orifice d'entrée (80), et une partie de buse (84) incluant un orifice de sortie (94) connecté de manière fluidique avec le passage de flux (82) pour produire un jet de vapeur de gaz, dans lequel la partie de buse (84) inclut un entonnoir (92) à travers lequel s'étend l'orifice de sortie (94).

2. L'appareil tel que décrit dans la revendication 1, comprenant en outre un contrôleur (68) agencé avec des premiers paramètres de contrôle qui contrôlent le dépôt du premier matériau source (32a) et des seconds paramètres de contrôle qui contrôlent le dépôt du second matériau source (32b), et au moins un paramètre de contrôle est différent entre les premiers paramètres de contrôle et les seconds paramètres de contrôle.

3. L'appareil tel que décrit dans une quelconque revendication précédente, dans lequel chacune des première et seconde chambres (12a, 12b) inclut une zone pour déposer respectivement le premier matériau (32a) et le second matériau (32b).

4. L'appareil tel que décrit dans une quelconque revendication précédente, comprenant en outre des première et seconde sources de faisceaux d'électrons (20a, 20b, 22a, 22b) agencées pour émettre des faisceaux d'électrons à l'intérieur des première et seconde chambres (12a, 12b), respectivement.

5. L'appareil tel que décrit dans une quelconque revendication précédente, comprenant en outre au moins une source de gaz (60) connectée, connectée directement de manière optionnelle, au premier creuset DVD (30a) et au second creuset DVD (30b).

6. L'appareil tel que décrit dans une quelconque revendication précédente, comprenant en outre un élément de transport (40) pour déplacer la pièce de travail entre les première et seconde chambres (12a, 12b).

7. L'appareil tel que décrit dans une quelconque revendication précédente, comprenant en outre un clapet de vanne (64) entre les première et seconde chambres (12a, 12b), de manière optionnelle pour isoler les chambres l'une de l'autre.

8. L'appareil tel que décrit dans la revendication 1, dans lequel l'orifice de sortie (94) a une section transversale ayant quatre côtés en ligne droite.

9. L'appareil tel que décrit dans la revendication 1, dans lequel l'orifice de sortie (94) a une section transversale rectiligne.

10. Une méthode destinée à être utiliser avec un appareil de dépôt en phase vapeur, la méthode comprenant de:
déposer un premier matériau (32a) sur une pièce de travail en utilisant un premier creuset (30a) de dépôt en phase vapeur dirigé (DVD) qui est au moins partiellement à l'intérieur d'une première chambre (12a) ; et
déposer un second matériau différent (32b) sur la pièce de travail en utilisant un second creuset (30b) de dépôt en phase vapeur dirigé (DVD) qui est au moins partiellement à l'intérieur d'une seconde chambre (12b) qui est adjacente à la première chambre (12a) ;
**caractérisée en ce que** chacun du premier creuset DVD (30a) et du second creuset DVD (30b) inclut un orifice d'entrée de gaz, une zone de chauffage pour présenter le premier matériau source ou le second matériau source correspondant, une passage de flux (82) exposé à la zone de chauffage (83) et connecté de manière fluidique avec l'orifice d'entrée (80), et une partie de buse (84) incluant un orifice de sortie (94) connecté de manière fluidique avec le passage de flux (82) pour produire un jet de vapeur de gaz, dans laquelle la partie de buse (84) inclut un entonnoir (92) à travers lequel s'étend l'orifice de sortie (94), dans laquelle déposer le premier revêtement et déposer le second revêtement inclut chacun de produire un jet de matériau de revêtement source évaporé dans un gaz vecteur jusqu'à la pièce de travail, la méthode comprenant en outre de :
produire un jet de matériau de revêtement source évaporé dans le gaz vecteur depuis l'orifice de sortie (94) de l'entonnoir (92).

11. La méthode telle que décrite dans la revendication 10, dans laquelle le dépôt du premier matériau (32a) et du second matériau (32b) inclut de déposer par dépôt physique en phase vapeur sous faisceau d'électrons.

12. La méthode telle que décrite dans la revendication 10 ou 11, comprenant en outre de contrôler le dépôt du premier matériau (32a) par des premiers paramètres de contrôle et de contrôler le dépôt du second matériau (32b) par des seconds paramètres de contrôle, dans laquelle au moins un paramètre de contrôle est différent entre les premiers paramètres de contrôle et les seconds paramètres de contrôle.

13. La méthode telle que décrite dans la revendication 10, dans laquelle l'orifice de sortie (94) a une section transversale ayant quatre côtés en ligne droite.

14. La méthode telle que décrite dans la revendication 10, dans laquelle l'orifice de sortie (94) a une section transversale rectiligne.
